# EUROPÄISCHE PATENTSCHRIFT

(11) **EP 2 044 627 B1**
(45) Veröffentlichungstag und Bekanntmachung des Hinweises auf die Patenterteilung: **07.11.2012**
(21) Anmeldenummer: 07730173.7
(22) Anmeldetag: 14.06.2007
(51) Int. Cl.: H01L 23/498, H05K 1/14, H01L 25/16

(54) **ELEKTRONIKANORDNUNG**
ELECTRONIC ARRANGEMENT
DISPOSITIF ÉLECTRONIQUE

(30) Priorität: 18.07.2006 DE 102006033175
(43) Veröffentlichungstag der Anmeldung: 08.04.2009
(73) Patentinhaber: Robert Bosch GmbH, 70442 Stuttgart (DE)
(72) Erfinder: RAICA, Thomas, 72379 Hechingen (DE); KOESTER, Thomas, 72762 Reutlingen (DE)
(86) Internationale Anmeldenummer: PCT/EP2007/055919
(87) Internationale Veröffentlichungsnummer: WO 2008/009524

(56) Entgegenhaltungen:
- EP-A- 1 143 514
- KR-A- 20030 077 203
- US-A1- 2005 205 970

## Beschreibung

### Stand der Technik

Die Erfindung betrifft eine Elektronikanordnung mit einem Leistungsteil und einem Logikteil.

Bekannte Elektronikeinheiten sehen eine räumliche Trennung zwischen Leistungsteil und Logikteil vor, also zwei einzelne, separate Baugruppen. Die Logik ist entweder auf einer Leiterplatte oder einem keramischen Substrat angeordnet. Ist für den Logikteil ein keramisches Substrat vorgesehen, so wird der Leistungsteil zumeist ebenfalls auf einem weiteren keramischen Substrat angeordnet, das mit Leistungsbauelementen bestückt ist. Das Leistungsteil weist "verpackte" Bauelemente auf, also Bauelemente, die jeweils eingehaust sind. Die bekannte Lösung hat die Nachteile einer eingeschränkten Miniaturisierbarkeit. Ferner ist die bekannte Lösung wenig flexibel und integrationsfähig für den Einsatz bei einer konkreten Anwendung. Die keramischen Substrate weisen ferner in Bezug auf die Handhabung keine hinreichende Robustheit auf .

Die US 2005/0205970 A1 offenbart eine Elektronikanordnung nach dem Oberbegriff des Anspruchs 1.

### Offenbarung der Erfindung

Bei der erfindungsgemäßen Elektronikanordnung, welche alle Merkmale des Anspruchs 1 aufweist und, die ein Leistungsteil und ein Logikteil aufweist, ist die Ausbildung als einteiliges Elektronikmodul vorgesehen, das sowohl das Leistungsteil als auch das Logikteil integral umfasst, wobei Leistungsteil und Logikteil zumindest teilweise in ein gemeinsames Moldgehäuse eingebettet sind. Die erfindungsgemäße Elektronikanordnung ist durch die Integration kompakt einstückig aufgebaut und durch das gemeinsame Moldgehäuse geschützt. Unter "Moldgehäuse" ist eine Verkapselung, insbesondere mittels Transfer-Molding-Verfahren, zu verstehen, d.h., die Elektronikanordnung wird in einen Werkstoff eingeschlossen, vorzugsweise mit einem Werkstoff, insbesondere Kunststoff, umspritzt, der aushärtet und einen sicheren Schutz bietet. Durch die aufgrund der Erfindung mögliche kompakte Anordnung ergibt sich eine Reduzierung des Bauraums und des Gewichts im Vergleich zu Elektronikanordnungen des Standes der Technik, die aus mehreren Einzelbaugruppen bestehen.

Nach einer Weiterbildung der Erfindung ist vorgesehen, dass das Leistungsteil als Tragteil mindestens ein Leistungssubstrat aufweist, das mindestens ein Leistungsbauelement, insbesondere mindestens einen Leistungshalbleiter, trägt. Als Leistungssubstrat kann insbesondere eine Leiterplatte oder eine keramische Platte zum Einsatz kommen. Auf dem Leistungssubstrat ist mindestens ein Leistungsbauelement angeordnet. In dieser Zone entsteht aufgrund der gegenüber dem Logikteil höheren Leistungsbereitstellung ein entsprechender Wärmeanfall, der gezielt abgeführt werden kann, ohne dass das Logikteil allzu sehr erwärmt wird. Demzufolge ist bevorzugt vorgesehen, dass das Logikteil als Tragelement mindestens ein Logiksubstrat aufweist, das mindestens ein Logikbauelement trägt. Leistungssubstrat und Logiksubstrat sind getrennt voneinander ausgebildet, jedoch gemeinsam im einteiligen Elektronikmodul enthalten. Auf dem Logiksubstrat, das insbesondere als Leiterplatte oder keramisches Substrat ausgebildet sein kann, sind die Bauelemente für die Logik der Elektronikanordnung angeordnet. Die Elektronikanordnung kann beispielsweise ein Steuergerät, zum Beispiel für einen Elektromotor, sein, wobei das Leistungsteil mit der Leistungselektronik den Elektromotor entsprechend der Vorgabe der von dem Logikteil erfolgenden Ansteuerung steuert oder regelt.

Eine Weiterbildung der Erfindung sieht vor, dass Logiksubstrat und Leistungssubstrat übereinander angeordnet sind. Hierunter ist zu verstehen, dass bei Horizontalanordnung der beiden Substrate diese mit Abstand zueinander, insbesondere parallel, übereinander liegen. Bevorzugt ist das Logiksubstrat oberhalb des Leistungssubstrats angeordnet.

Für die Verdrahtung von Logiksubstrat und Leistungssubstrat beziehungsweise deren jeweilige Bauelemente untereinander kann insbesondere die Bond-Verbindungstechnik eingesetzt werden. Es sind jedoch auch andere Verbindungstechniken denkbar, wie Flexverbindungen (flexible Verbindungen, insbesondere flexible Flachleitungen) und/oder Durchkontaktierungen. Zusätzlich oder alternativ sind auch Lötverbindungen denkbar.

Eine Weiterbildung der Erfindung sieht vor, dass das mindestens eine Leistungsbauelement mit dem Leistungssubstrat über mindestens eine Bond-Verbindung elektrisch verbunden ist. Dies gilt insbesondere für Anschlüsse des Leistungsbauelements, die abgewandt vom Leistungssubstrat liegen. Sofern das Leistungsbauelement elektrische Anschlüsse aufweist, die dem Leistungssubstrat zugewandt sind, können diese insbesondere über Lötverbindungen an entsprechende Strompfade des Leistungssubstrats angeschlossen werden.

Eine Weiterbildung der Erfindung sieht vor, dass die Rückseite des Logiksubstrats mindestens eine elektrische Verbindungsfläche für die angrenzende Vorderseite des mindestens einen Leistungsbauelements aufweist. Die Anordnung ist vorzugsweise derart getroffen, dass auf der Vorderseite des Leistungsbauelements elektrische Anschlüsse liegen, die mit entsprechenden Strompfaden an der Rückseite des Logiksubstrats insbesondere durch Lötstellen elektrisch verbunden werden. Hierdurch ergibt sich ein sehr kompakter und einfacher Aufbau.

Nach einer Weiterbildung der Erfindung ist die Vorderseite des Logiksubstrats außerhalb des Moldgehäuses angeordnet. Die Rückseite des Logiksubstrats liegt bevorzugt im Moldgehäuse. Bei dieser Anordnung ist somit der Logikteil nicht komplett in das Moldgehäuse eingebettet, sondern nur in Bezug auf seine Unterseite. Die auf der Vorderseite des Logikteils liegenden Logikkomponenten sind daher von außen her zugänglich.

### Kurze Beschreibung der Zeichnungen

Die Zeichnungen veranschaulichen die Erfindung anhand von drei Ausführungsbeispielen und zwar zeigt:
- Figur 1: einen Querschnitt durch ein erstes Ausführungsbeispiel einer Elektronikanordnung,
- Figur 2: ein weiteres Ausführungsbeispiel einer Elektronikanordnung im Querschnitt und
- Figur 3: ein weiteres Ausführungsbeispiel einer Elektronikanordnung im Querschnitt.

### Ausführungsform(en) der Erfindung

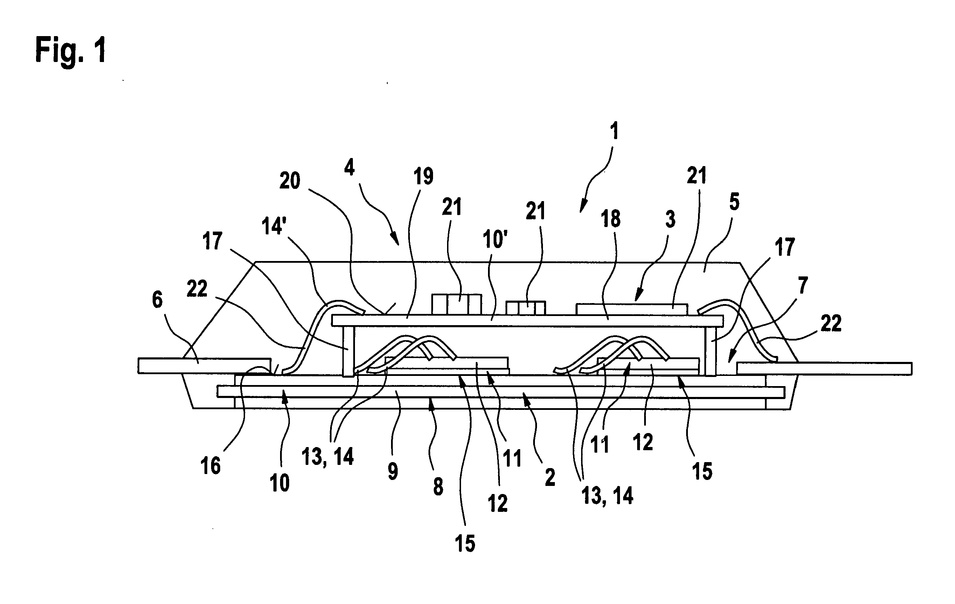

Die Figur 1 zeigt eine Elektronikanordnung 1, die ein Leistungsteil 2 und ein Logikteil 3 aufweist. Die Elektronikanordnung 1 ist als einteiliges Elektronikmodul 4 ausgebildet, dass sowohl das Leistungsteil 2 als auch das Logikteil 3 integral umfasst, wobei Leistungsteil 2 und Logikteil 3 im Ausführungsbeispiel der Figur 1 vollständig und gemeinsam in einem Moldgehäuse 5 eingebettet sind. In Figur 1 ist eine Hauptplatine 6 (Leadframe) vorgesehen, die ein Fenster 7 aufweist, in der die Elektronikanordnung 1 bereichsweise angeordnet ist, wobei das Moldgehäuse 5 mit an die Hauptplatine 6 angespritzt ist. Bei dem Moldgehäuse 5 handelt es sich um ein aus Kunststoff gespritztes Gehäuse, d.h., nach Fertigstellung des elektrischen Aufbaus der Elektronikanordnung 1 wird dieser mit Kunststoff umspritzt.

Das Leistungsteil 2 weist ein Leistungssubstrat 8 auf, das als keramisches Substrat 9 ausgebildet ist. Das Leistungssubstrat 8 bildet ein Tragelement 10 für die Bauteile des Leistungsteils 2, insbesondere für Leistungsbauelemente 11, die als Leistungshalbleiter 12 ausgebildet sind. Mittels Bond-Verbindungen 13, die als Bond-Drähte 14 ausgebildet sind, sind die Leistungsbauelemente 11 mit entsprechenden Strompfaden des Leistungssubstrats 8 verbunden. Ferner bestehen Lötverbindungen 15 zwischen der Vorderseite 16 des Leistungssubstrats 8 und den Leistungsbauelementen 11.

Mittels Abstandshalter 17 wird ein Logiksubstrat 18, das als keramisches Substrat 19 ausgebildet ist, oberhalb des Leistungssubstrats 8 an diesem gehalten, derart, dass sich zumindest ein Anteil der Bauelemente des Leistungsteils 2 unterhalb des Logiksubstrats 18 befinden. Das Logiksubstrat 18 bildet ein Trageelement 10'. Auf der Vorderseite 20 des Logiksubstrats 18 sind Logikbauelemente 21 angeordnet. Hierunter sind auch Logikkomponenten zu verstehen. Mittels Bond-Verbindungen 22, die als Bond-Drähte 14' ausgebildet sind, ist das Logiksubstrat 18 mit dem Leistungssubstrat 8 und/oder der Hauptplatine 6 elektrisch verbunden. Die gesamte, vorstehend beschriebene Anordnung zusammen mit den erwähnten Bond-Verbindungen 13, 22 befindet sich innerhalb des Moldgehäuses 5.

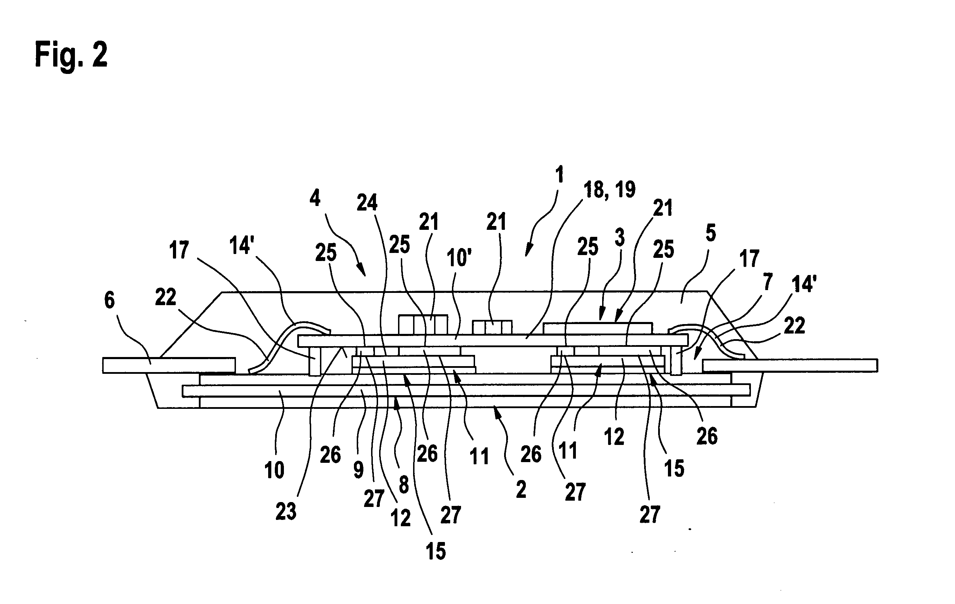

Die erfindungsgemäβe Elektronikanordnung 1 der Figur 2 unterscheidet sich nur teilweise vom Ausführungsbeispiel der Figur 1, sodass nachstehend nur auf die Unterschiede eingegangen wird. Alles Übrige entspricht der Ausgestaltung des Ausführungsbeispiels der Figur 1. Beim Ausführungsbeispiel der Figur 2 sind die Abstandshalter 17 derart kurz ausgebildet, dass die Rückseite 23 des Logiksubstrats 18 direkt an die Vorderseite 24 der Leistungsbauelemente 11 angrenzt, sodass elektrische Verbindungsflächen 25 (Strompfade) an der Rückseite 23 des Logiksubstrats 18 über Lötverbindungen 26 mit entsprechenden Kontaktstellen 27 der Leistungsbauelemente 11 elektrisch verbunden sind. Hierdurch wird ein besonders flacher Aufbau erzielt.

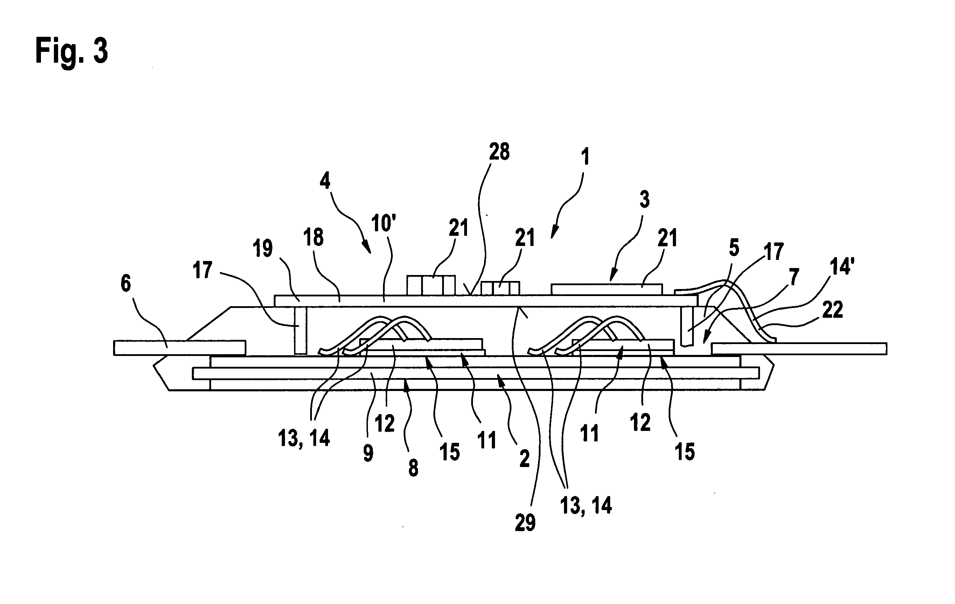

Das Ausführungsbeispiel der Figur 3 zeigt eine Elektronikanordnung 1, die sich vom Ausführungsbeispiel der Figur 1 dadurch unterscheidet, dass das Moldgehäuse 5 das Logikteil 8 nicht komplett umgibt, sodass die Vorderseite 28 des Logiksubstrats 18 außerhalb des Moldgehäuses 5 liegt und nur die Rückseite 29 des Logiksubstrats 18 im Moldgehäuse 5 eingebettet ist. Mindestens eine Bondverbindung 22, die vom Logikteil 3 zur Hauptplatine 6 führt, liegt daher außerhalb des Moldgehäuses 5.

Aufgrund der Erfindung wird ein Elektronikmodul geschaffen, dass das Leistungsteil und das Logikteil, also das Ansteuerteil für das Leistungsteil enthält. Gegebenenfalls kann das Logikteil auch Sensorikbauelemente aufweisen. Ferner weist die erfindungsgemäße Elektronikanordnung die für den Aufbau erforderlichen Schaltungsträger (Substrate) und das Gehäuse auf, das als Moldgehäuse ausgebildet ist.

Insbesondere kann vorgesehen sein, dass ein oder mehrere Leistungshalbleiter auf das Leistungssubstrat, wie zum Beispiel ein DCB-Substrat (DCB = direct copper bonding), montiert werden. Dabei erfolgt die Verschaltung (Kontaktierung) der Leistungskomponenten untereinander entweder durch sogenannte Bonds und/oder Lötverbindungen, bevorzugt zweiseitige Lötverbindungen, insbesondere in einem Sandwichsaufbau. Die Leistungsbauelemente werden vorzugsweise gelötet, um eine optimale Entwärmung sicherstellen zu können. Zusätzlich oder alternativ kann als Verbindungstechnik auch Niedertemperatursintern zum Einsatz kommen. Für Anwendungen, bei denen hohe thermische Verluste auftreten, erfolgt die Entwärmung des Leistungsteils insbesondere über die Substratrückseite, also die Leistungssubstratrückseite. In einem solchen Fall ist vorgesehen, sie bei der Ausbildung des Gehäuses nicht mit abzudecken, d.h., die Substratrückseite bleibt im Moldprozess freigestellt. Für Anwendungen mit geringeren Verlustleistungen kann die Entwärmung über die Hauptplatine (Leadframe) ausreichend sein, sodass die vorstehend erwähnte Freistellung nicht notwendig ist und hierdurch der Aufwand reduziert wird.

Das Logikteil wird vorzugsweise auf einem Keramiksubstrat oder einer üblichen Leiterplatte aufgebaut. Das jeweilige Substrat wird in das Moldgehäuse zumindest bereichsweise oder vollständig integriert. Ferner wird das Logiksubstrat bevorzugt oberhalb des Leistungsteils positioniert. Die Kontaktierung erfolgt bevorzugt mittels Bonden und/oder Flexverbinder (Flexfolie). Das Logiksubstrat kann im Aufbau als Sandwich ausgebildet sein. Zusätzlich oder gleichzeitig ist es möglich, dass die Rückseite des Logiksubstrats zur Kontaktierung der Oberseite der Leistungsbauteile verwendet wird.

In einer speziellen Ausführungsform ist vorgesehen, dass das Logiksubstrat auf das Gehäuse, also auf das Moldpackage aufgesattelt wird. In diesem Falle erfolgt die Verdrahtung zwischen Logikteil und Leistungsteil über das Leadframe, eventuell in Kombination mit Flexverbinder. Die Bestückung der Ansteuerlogik und einer gegebenenfalls vorgesehenen Sensorik erfolgt vor der Montage des Logiksubstrats auf das Leistungssubstrat. Die Vorpositionierung des Logiksubstrats erfolgt bevorzugt über einfache Abstandshalter, die vorzugsweise aus Kupfer oder Keramik bestehen können.

Aufgrund der Erfindung ergibt sich eine Miniaturisierung des Aufbaus. Vorteilhaft für die direkte Integration der Elektronik in die jeweilige Anwendung ist aufgrund der Erfindung die Reduzierung des

Bauraums und Gewichts durch den Entfall externer Schaltungsträger, externer Verdrahtungselemente und weiterer Passivierungsmaßnahmen. Bei der Erfindung kommen bevorzugt Bare-Die-Bauelemente (unverpackte Bauelemente) für die Leistungsbauteile und die vorzugsweise aktiven Logikbauteile zur Anwendung, d.h., es werden platzintensive vorverpackte Bauelemente vermieden. Ferner lassen sich durch den Einsatz von Bare-Die-Bauelementen die Abmessungen der Substrate (Tragelemente) im Vergleich zur üblichen Technik kleiner gestalten, wodurch sich trotz Verwendung hochwertiger Substrate Kostenvorteile ergeben.

Als Logiksubstrat wird vorzugsweise eine Keramik eingesetzt, die die Bestückung von Bare-Die-Bauelementen ermöglicht, wodurch auf eine Doppelverpackung von Bauelementen verzichtet wird. Die Bestückung einer Vielzahl von Logiksubstraten ist insbesondere als Großkarte möglich, wodurch eine Reihe von Fertigungsschritten, wie beispielsweise der Druck von Leitkleber kostengünstig parallel erfolgen kann. Zum Erhalt der einzelnen Logiksubstrate wird die Großkarte in Einzelelemente aufgetrennt. Alternativ ist es auch denkbar, das Substrat als Einzelsubstrat zu bestücken. Die Bestückung mit Bare-Die-Bauelementen kann auch im Flip-Chip-Technik realisiert werden, wodurch gegebenenfalls eine Reduzierung der benötigten Substratfläche möglich ist, was sich vorteilhaft auf die Modulbaugröße und den beanspruchten Bauraum in der jeweiligen Anwendung (Applikation) auswirkt. Die Bestückung in Flip-Chip-Technik kann sowohl in Form eines Löt- oder Klebe-Flip-Chips erfolgen, vorzugsweise allerdings als Klebeverbindung, da dieser Prozess besonders einfach bei Bestückungsvorgängen des Substrates realisiert werden kann.

Die erwähnten Bare-Die-Bauelemente weisen deutlich weniger Bauraum auf, da sie keine Standardgehäuse aufweisen. Da das gesamte Modul mit einem Gehäuse (Moldgehäuse) versehen ist, können hierdurch Kosten verursachende Doppelverpackungen der Bauelemente vermieden werden.

Bei der Erstellung des Gehäuses wird bevorzugt Niederdruck-Epoxidpressmasse eingesetzt. Die Ausführung des gesamten Modulgehäuses in Form eines im Transfer-Molding-Verfahren hergestellten Gehäuses ist vorteilhaft, da die für dieses Verfahren eingesetzten umweltverträglichen sogenannten Green Compounds Niederdruck Epoxidmassen besonders gut geeignet sind, die im Modul auftretenden Spalte blasenfrei zu füllen und die elektrischen Bauelemente, insbesondere die Bare-Die-Bauelemente, vor Umwelteinflüssen (zum Beispiel Flüssigkeiten, Staub und so weiter) zu schützen. Des weiteren sind diese Kunststoffe aufgrund ihrer physikalischen Eigenschaften gut geeignet, mögliche thermomechanische Fehlanpassungen der eingesetzten Komponenten auszugleichen. Ferner wird aufgrund der erwähnten Epoxidmassen eine hohe mechanische Stabilisierung des Aufbaus erzielt.

Bei dem erfindungsgemäßen Modul sind Logik- und Leistungsteil vollständig von dem Moldgehäuse umschlossen und somit elektrisch isoliert. Hierdurch kann auf die Montage von zusätzlichen, elektrisch isolierenden Elementen, wie beispielsweise isolierende Folien, verzichtet werden, wodurch sowohl die Kosten des Isolationsmaterials, als auch die Kosten von dessen Montage eingespart werden.

Insbesondere ermöglicht die ebene Anordnung von Leistungssubstrat und Logiksubstrat eine einfache Skalierbarkeit des Moduls hinsichtlich Größe und Anzahl der eingesetzten Halbleiter. Dies ist insbesondere vorteilhaft, wenn bei einer Anwendung Leistungshalbleiter unterschiedlichen Typs Verwendung finden sollen, die sich in den Dimensionen (Länge, Breite, Dicke) unterscheiden. Aufgrund der erfindungsgemäßen Zusammenfassung der beschriebenen Baugruppen ergibt sich eine Reduzierung der Schnittstellenanzahl. Durch eine multifunktionelle Verwendung von Komponenten, wie zum Beispiel Stanzgitter, kann die Anzahl an Fügeprozeßschritten reduziert werden, wobei gleichzeitig eine gute Verbindungsqualität garantiert ist.

Insbesondere kann vorgesehen sein, dass die erfindungsgemäße Elektronikanordnung in entsprechende Applikationen integriert ist, beispielsweise in eine elektrische Maschine. Ferner können EMV-Maßnahmen in erfindungsgemäßen Modul vorgesehen sein (EMV = Elektromagnetische Verträglichkeit).

In einer speziellen Ausführungsform ist die erfindungsgemäße Elektronikanordnung als Modul mit Leistungs- und Logikteil zur Ansteuerung eines Elektromotors vorgesehen. Dabei handelt es sich um ein Leistungsteil, das eine Brückenschaltung, zum Beispiel eine B6-Brücke (B6 ist ein stehender Begriff für eine Verschaltungskonfiguration), aufweist, die aus Leistungstransistoren und Dioden besteht. Das Logikteil weist ein Gatetreiber-IC mit dessen externer Beschaltung sowie optional zugehörige Sensorik auf. Als Substrat oder Substrate für das Leistungsteil und/oder das Logikteil wird beispielsweise eine DCB-Keramik (direct bonded copper) oder eine Hybridkeramik eingesetzt.

Die Bestückung von Logiksubstraten erfolgt als Großkarte, auf der zunächst mittels eines Sieb- oder Schablonendrucks Leitkleber aufgebracht wird. Anschließend erfolgt die Bestückung der Großkarte mit den aktiven und passiven Bauelementen. Passive Bauelemente werden bevorzugt in SMD-Technik (SMD = surface mounted device) und aktive mit Die-Attach (Montagetechnik: Rückseite auf das Substrat) aufgebracht. Nach dem Aushärten des Leitklebers in einem Ofen werden die aktiven Bauelemente gebondet. Prinzipiell ist es auch möglich oder zusätzlich möglich, die aktiven Bauelemente in Flip-Chip-Technik zu bestücken. Anschließend erfolgt das Vereinzeln der Großkarte in Einzelsubstrate, die im weiteren Modulaufbau dann verarbeitet werden. Alternativ zur Klebetechnik ist auch das Auflöten der Bauelemente, insbesondere alternativ oder vereinzelt sogar als verpackte Bauelemente, möglich.

Der Aufbau des Leistungsmoduls beginnt bevorzugt mit Lötpastendruck auf das Leistungssubstrat und Bestücken mit Leistungsbauelementen. Ferner wird das Lead-Frame bestückt und eventuelle Zusatzkomponenten auf das Leistungssubstrat, insbesondere aus DCB-Keramik, aufgebracht. Anschließend erfolgt ein Verlöten. Danach werden alle Bondverbindungen ausgeführt. Die Montage des Logiksubstrats kann anschließend auf vorab aufgelöteten oder aufgeklebten Sockeln (Abstandshalter) erfolgen. Der so entstandene Verbund durchläuft bei Bedarf einen Erwärmungsprozess (Ofen) in dem der Kleber an- beziehungsweise ausgehärtet wird. Nach dem Ofenprozess werden noch ausstehende Verbindungen zwischen Logiksubstrat und dem Leistungssubstrat beispielsweise durch Bonds oder Flexfolie hergestellt.

Anschließend erfolgt die Verkapselung mittels Transfer-Molding Verfahrens, bei dem die Elektronik der Elektronikanordnung in der Kavität einer Moldform mit Kunststoff umspritzt wird, wodurch das Gehäuse des Elektronikmoduls ausgebildet wird. Das Moldwerkzeug besteht aus einem Ober- und Unterteil, die nach dem Einlegen der Elektronikanordnung geschlossen werden und die Kavität auf einem Stanzgitter, insbesondere einer sogenannten Dam-Bar, abdichten. Anschließend erfolgt der eigentliche Spritzprozess, der mit erhöhter Temperatur und Druck durchgeführt wird. Sobald der Kunststoff im Werkzeug vernetzt ist, wird die Moldform geöffnet und das Modul ausgestoßen beziehungsweise entnommen. Je nach eingesetztem Kunststoff und Anforderungen an die Verpackung (Gehäuse) ist optional ein Nachhärten als sogenanntes PMC (post-mold-cure) in einem Ofenverfahrensschritt möglich.

Nach dem Molden sind die einzelnen Funktionselemente beziehungsweise -bereiche des Stanzgitters mittels der Dam-Bar miteinander verbunden, wodurch sich das Stanzgitter als ein Teil im Montageprozess handhaben lässt. Diese Verbindung bedingt, dass alle elektrischen Kontakte kurzgeschlossen sind, d.h., zur Herstellung der elektrischen Funktion werden diese Verbindungsstellen beispielsweise durch einen Stanzprozess aufgetrennt. Gegebenenfalls kann mit dem Stanzprozess ein Biegeprozess zur applikationsspezifischen Gestaltung der elektrischen und mechanischen Schnittstellen zur jeweiligen Anwendung kombiniert werden.

Je nach Applikation kann das Modul in unterschiedlicher Weise in dieser montiert werden. Bei einer Integration von Sensorik kann jedoch eine spezielle Orientierung erforderlich sein, zum Beispiel derart, dass das Logikteil in Richtung Motorachse des erwähnten Elektromotors zeigt, wenn beispielsweise als Sensorik Hall-Sensoren über einem Polrad des Elektromotors positioniert werden müssen. In diesem Falle ist die Positionierung des oder der Sensoren innerhalb des Moduls und die Positionierung des Moduls in der Applikation abzustimmen. Dabei können insbesondere die Abstandsanforderungen, beispielsweise bei Hall-Sensoren, dazu führen, dass das Gehäuse im Bereich der Sensoren Konturen aufweist, die es erlauben, die geforderten Abstände einzuhalten und gleichzeitig Bauelemente mit größerer Dicke, im Vergleich zu den erwähnten Hall-Sensoren, zu verbauen.

Im einfachsten Fall wird das erfindungsgemäße Modul ohne weitere Maßnahme direkt in die Applikation montiert. Dies kann insbesondere durch Schrauben oder Klemmen erfolgen. Denkbar ist es aber auch, dass das Modul beispielsweise nur in ein Teil des Gehäuses der Applikation eingelegt wird und durch die Montage eines Deckels der Applikation oder durch einen zusätzlichen Verguss fixiert wird.

## Patentansprüche

1. Elektronikanordnung mit einem Leistungsteil (2) und einem Logikteil, das als einteiliges Elektronikmodul (4) ausgebildet ist, das sowohl das Leistungsteil (2) als auch das Logikteil (3) integral umfasst, wobei Leistungsteil (2) und Logikteil (3) zumindest teilweise in ein gemeinsames Moldgehäuse (5) eingebettet sind und wobei das Leistungsteil (2) als Tragteil (10) mindestens ein Leistungssubstrat (8) aufweist, das mindestens ein Leistungsbauelement (11), insbesondere mindestens einen Leistungshalbleiter (12), trägt, und das Logikteil (3) als Tragelement (10') mindestens ein Logiksubstrat (18) aufweist, das mindestens ein Logikbauelement (21), insbesondere mindestens einen Logikhalbleiter, trägt, **dadurch gekennzeichnet, dass** die Rückseite (23) des Logiksubstrats (18) mindestens eine elektrische Verbindungsfläche (25) aufweist, welche mit der angrenzenden Vorderseite (24) des mindestens einen Leistungsbauelements (11) über Lötverbindungen (26) elektrisch verbunden ist.

2. Elektronikanordnung nach einem der vorhergehenden Ansprüche,
**dadurch gekennzeichnet, dass** Logiksubstrat (18) und Leistungssubstrat (8) übereinander angeordnet sind.

3. Elektronikanordnung nach einem der vorhergehenden Ansprüche,
**dadurch gekennzeichnet, dass** Logikteil (3) und Leistungsteil (2), insbesondere Logiksubstrat (18) und Leistungssubstrat (8), über mindestens eine Bondverbindung (13, 22) elektrisch miteinander verbunden sind.

4. Elektronikanordnung nach einem der vorhergehenden Ansprüche,
**dadurch gekennzeichnet, dass** das mindestens eine Leistungsbauelement (11) mit dem Leistungssubstrat (8) über mindestens eine Bondverbindung (13, 22) elektrisch verbunden ist.
Ansprüche, dass die Rückseite (23) des mindestens eine elektrische

5. Elektronikanordnung nach einem der vorhergehenden Ansprüche, **dadurch gekennzeichnet, dass** die Vorderseite (28) des Logiksubstrats (18) außerhalb des Moldgehäuses (5) liegt.

6. Elektronikanordnung nach einem der vorhergehenden Ansprüche, **dadurch gekennzeichnet, dass** die Rückseite (29) des Logiksubstrats (18) im Moldgehäuse (5) liegt.

## Claims

1. Electronics arrangement having a power section (2) and a logic section which is formed as an integral electronics module (4) which integrally comprises both the power section (2) and the logic section (3), wherein the power section (2) and the logic section (3) are at least partially embedded in a common mould housing (5), and wherein the power section (2), as a the supporting section (10), has at least one power substrate (8) which supports at least one power component (11), in particular at least one power semiconductor (12), and the logic section (3), as a supporting element (10'), has at least one logic substrate (18) which supports at least one logic component (21), in particular at least one logic semiconductor, **characterized in that** the rear face (23) of the logic substrate (18) has at least one electrical connection area (25) which is electrically connected to the adjacent front face (24) of the at least one power component (11) by means of solder connections (26).

2. Electronics arrangement according to Claim 1, **characterized in that** the logic substrate (18) and the power substrate (8) are arranged one above the other.

3. Electronics arrangement according to either of the preceding claims, **characterized in that** the logic section (3) and the power section (2), in particular the logic substrate (18) and the power substrate (8), are electrically connected to one another by means of a bonding connection (13, 22).

4. Electronics arrangement according to one of the preceding claims, **characterized in that** the at least one power component (11) is electrically connected to the power substrate (8) by means of at least one bonding connection (13, 22).

5. Electronics arrangement according to one of the preceding claims, **characterized in that** the front face (28) of the logic substrate (18) is situated outside the mould housing (5).

6. Electronics arrangement according to one of the preceding claims, **characterized in that** the rear face (29) of the logic substrate (18) is situated in the mould housing (5).

## Revendications

1. Ensemble électronique qui présente une partie de puissance (2) et une partie logique et qui est configuré comme module électronique (4) d'une seule pièce qui comporte à la fois la partie de puissance (2) et la partie logique (3),
la partie de puissance (2) et la partie logique (3) étant incorporées au moins en partie dans un boîtier moulé (5) commun et la partie de puissance (2) présentant comme partie de support (10) au moins un substrat de puissance (8) qui porte au moins un composant de puissance (11) et en particulier au moins un semi-conducteur de puissance (12),
la partie logique (3) présentant comme élément de support (10') au moins un substrat logique (18) qui porte au moins un composant logique (21) et en particulier au moins un semi-conducteur logique, **caractérisé en ce que**
le côté dorsal (23) du substrat logique (18) présente au moins une surface de liaison électrique (25) reliée électriquement par des liaisons brasées (26) à la face avant (24) adjacente du ou des composants de puissance (11).

2. Ensemble électronique selon la revendication 1, **caractérisé en ce que** le substrat logique (18) et le substrat de puissance (8) sont disposés l'un au-dessus de l'autre.

3. Ensemble électronique selon l'une des revendications précédentes, **caractérisé en ce que** la partie logique (3) et la partie de puissance (2) et en particulier le substrat logique (18) et le substrat de puissance (8) sont reliés électriquement l'un à l'autre par au moins une liaison (13, 22).

4. Ensemble électronique selon l'une des revendications précédentes, **caractérisé en ce que** le ou les composants de puissance (11) sont reliés électriquement au substrat de puissance (8) par au moins une liaison (13, 22).

5. Ensemble électronique selon l'une des revendications précédentes, **caractérisé en ce que** la face avant (28) du substrat logique (18) est située à l'extérieur du boîtier moulé (5).

6. Ensemble électronique selon l'une des revendications précédentes, **caractérisé en ce que** la face arrière (29) du substrat logique (18) est située dans le boîtier moulé (5).
